# FASCICULE DE BREVET EUROPEEN

(11) **EP 4 262 228 B1**
(45) Date de publication et mention de la délivrance du brevet: **13.03.2024**
(21) Numéro de dépôt: 23166426.9
(22) Date de dépôt: 04.04.2023
(51) Int. Cl.: H04N 25/709, H04N 25/766, H04N 25/77, H04N 25/78

(54) **MATRICE DE PIXELS**
PIXELMATRIX
PIXEL ARRAY

(30) Priorité: 13.04.2022 FR 2203404
(43) Date de publication de la demande: 18.10.2023
(73) Titulaire: Commissariat à l'énergie atomique et aux énergies alternatives, 75015 Paris (FR)
(72) Inventeur: AYEL, François, 38054 GRENOBLE CEDEX 09 (FR)
(74) Mandataire: Cabinet Beaumont

(56) Documents cités:
- FR-A1- 3 089 682
- FR-A1- 3 100 925
- US-B1- 7 847 846

## Description

### Domaine technique

La présente description concerne de façon générale le domaine des capteurs d'image, et en particulier une matrice de pixels et un procédé de commande d'une matrice de pixels.

### Technique antérieure

Dans les capteurs d'image CMOS (de l'anglais "Complementary Métal Oxide Semiconductor" - métal oxyde semiconducteur complémentaire), en général un niveau de tension produit par une photodiode d'un pixel du capteur est lu en utilisant un transistor du pixel monté dans une configuration de suiveur de tension. Ce transistor a par exemple l'un de ses noeuds de conduction couplé à un rail d'alimentation, et son autre noeud de conduction couplé à une ligne de sortie, par exemple par l'intermédiaire d'un transistor de sélection de ligne aussi appelé transistor de lecture. On utilise par exemple une source de courant pour tirer un courant sur la ligne de sortie, et cela permet de lire la tension présente au niveau de la grille du transistor suiveur de tension.

### Résumé de l'invention

Il existe un besoin d'un capteur d'image ou de lumière CMOS et d'un procédé de commande du capteur palliant tout ou partie des inconvénients des capteurs d'image ou de lumière CMOS connus et de leurs procédés de commande connus.

Un mode de réalisation pallie tout ou partie des inconvénients des capteurs d'image ou de lumière CMOS connus et de leurs procédés de commande connus.

Un mode de réalisation prévoit une matrice de pixels, comprenant :
- un ou plusieurs pixels comprenant chacun un premier transistor ayant : son noeud de commande couplé à une photodiode ; un premier de ses noeuds de conduction principaux couplé à un premier rail de tension de sortie ; et un deuxième de ses noeuds de conduction principaux couplé à un deuxième rail de tension ;
- une impédance variable couplant le premier rail de tension à un premier rail d'alimentation de la matrice de pixels ;
- une source de courant couplant le deuxième rail de tension à un deuxième rail d'alimentation de la matrice de pixels, l'impédance variable étant contrôlée sur la base d'une tension sur le deuxième rail de tension ; et
- un premier commutateur couplant le deuxième rail de tension à un troisième rail de tension.

Selon un mode de réalisation, la matrice de pixels comprend en outre un amplificateur différentiel ayant une première entrée couplée au deuxième rail de tension, une deuxième entrée couplée à une tension de référence, et une sortie couplée à une entrée de commande de l'impédance variable.

Selon un mode de réalisation, la matrice de pixels comprend un circuit configuré pour fournir la tension de référence et pour modifier la tension de référence au moins en fonction de la température.

Selon un mode de réalisation, une tension du troisième rail de tension est configurée pour qu'une fermeture du premier commutateur rende l'impédance variable équivalente à un circuit ouvert.

Selon un mode de réalisation, la matrice de pixels comprend en outre un deuxième commutateur couplant le premier rail de tension à un quatrième rail de tension.

Selon un mode de réalisation, la tension du quatrième rail de tension est plus proche d'une tension sur le deuxième rail d'alimentation que d'une tension sur le premier rail d'alimentation.

Selon un mode de réalisation, chaque pixel comprend en outre un deuxième transistor couplant le noeud de commande du premier transistor à un rail de tension de réinitialisation, et un troisième transistor couplant le premier noeud de conduction du premier transistor au premier rail de tension.

Selon un mode de réalisation, une tension du rail de tension de réinitialisation détermine une valeur de la tension du quatrième rail de tension.

Selon un mode de réalisation, chaque pixel comprend en outre une porte de transfert couplant le noeud de commande du premier transistor à la photodiode.

Un mode de réalisation prévoit un procédé de commande d'un pixel d'une matrice de pixels, le procédé comprenant, pour chaque opération de lecture du pixel, une fermeture d'un premier commutateur couplant un deuxième rail de tension à un troisième rail de tension, le deuxième rail de tension étant couplé à un deuxième noeud de conduction d'un premier transistor du pixel ayant un premier noeud de conduction couplé à un premier rail de tension de sortie et un noeud de commande couplé à une photodiode du pixel, le premier rail de tension étant couplé à un premier rail d'alimentation par une impédance variable et le deuxième rail de tension étant couplé à un deuxième rail d'alimentation par une source de courant, l'impédance variable étant commandée sur la base d'une tension sur le deuxième rail de tension.

Selon un mode de réalisation, une tension du troisième rail de tension est configurée pour qu'une fermeture du premier commutateur rende l'impédance variable équivalente à un circuit ouvert.

Selon un mode de réalisation :
- chaque pixel comprend en outre un deuxième transistor couplant le noeud de commande du premier transistor à un rail de tension de réinitialisation, et un troisième transistor couplant le premier noeud de conduction du premier transistor au premier rail de tension ; et
- la fermeture du premier commutateur est mise en oeuvre avant une période où le troisième transistor est maintenu passant.

Selon un mode de réalisation, un deuxième commutateur couple un quatrième rail de tension au premier rail de tension et est commuté à l'état passant pendant que le premier commutateur est fermé.

Selon un mode de réalisation, une tension du rail de tension de réinitialisation détermine une valeur de la tension du quatrième rail de tension.

Selon un mode de réalisation, la tension du quatrième rail de tension est plus proche d'une tension sur le deuxième rail d'alimentation que d'une tension sur le premier rail d'alimentation.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre un exemple d'un capteur d'image ;
la figure 2 illustre un exemple d'un pixel du capteur d'image de la figure 1 ;
la figure 3 illustre un exemple de fonctionnement du capteur de la figure 1 ;
la figure 4 illustre un autre exemple d'un capteur d'image ;
la figure 5 illustre un exemple de pixel du capteur de la figure 4 ;
la figure 6 illustre un mode de réalisation d'un capteur d'image ; et
la figure 7 illustre un autre mode de réalisation d'un capteur d'image.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des rangées et des colonnes de pixels dans une matrice de pixels n'ont pas été décrits en détail, de tels circuits étant bien connus de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf indications contraire, une tension d'un noeud ou d'un rail correspond au potentiel de ce noeud ou de ce rail référencé à un potentiel de référence, par exemple le potentiel de masse GND.

Sauf précision contraire, une même référence peut désigner à la fois un rail conducteur et une tension sur ce rail conducteur.

Les documents FR3089682 (B1), US2020185441 (A1) et CN111277775 (A) décrivent une matrice de pixels d'un capteur d'image ou de lumière CMOS.

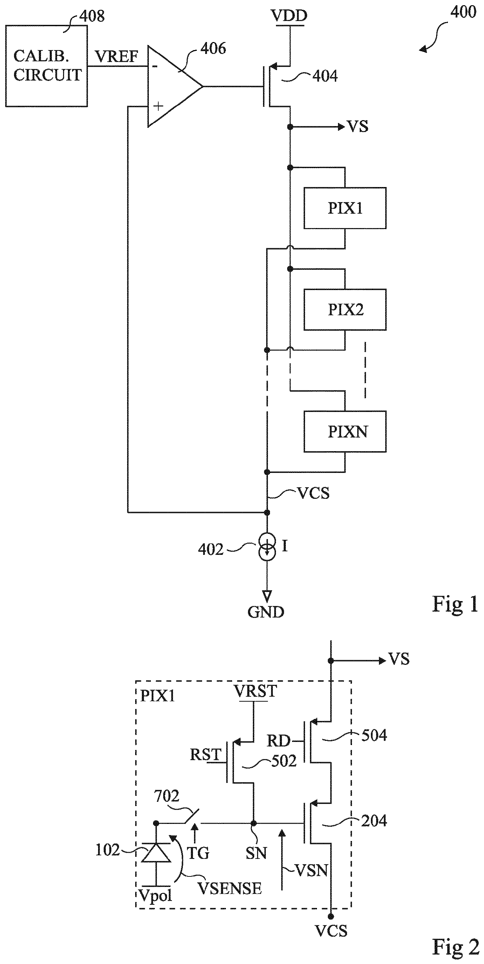

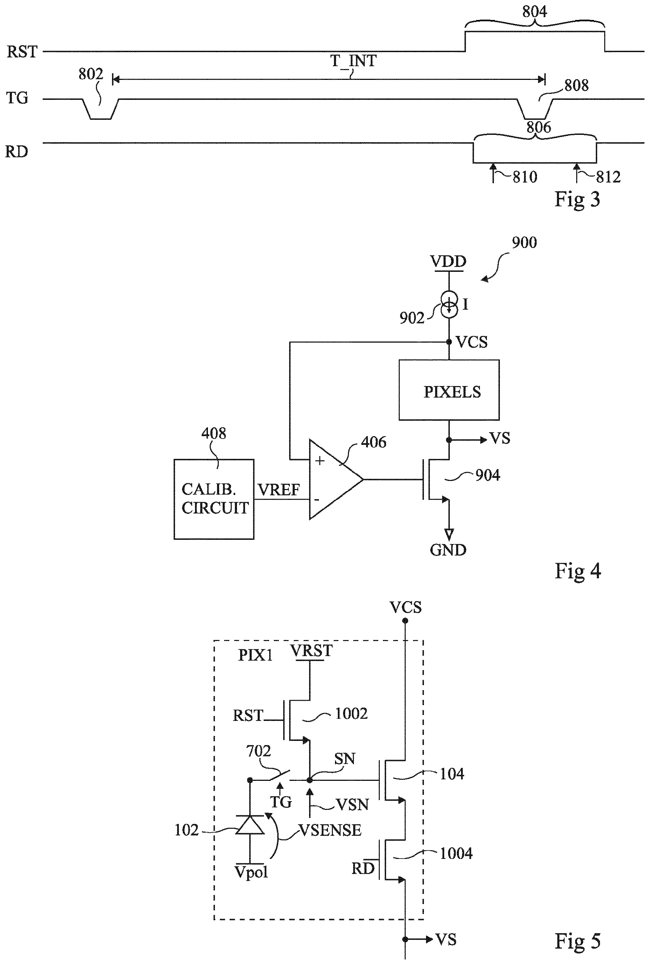

La figure 1 est une reproduction de la figure 4 des documents susmentionnés. Plus particulièrement, la figure 1 illustre schématiquement un exemple d'une colonne 400 d'une matrice de pixels d'un capteur d'image ou de lumière, la matrice pouvant comprendre une pluralité de colonnes 400.

La colonne 400 de la figure 1 comprend par exemple N circuits de pixels PIX1 à PIXN, où N est par exemple égal à au moins deux. Dans d'autres exemples, la colonne 400 pourra toutefois comprendre un seul circuit de pixel. De préférence, les N circuits de pixels PIX1 à PIXN sont identiques les uns aux autres.

Chaque circuit de pixel est couplé entre un rail de tension de sortie VS et un autre rail de tension VCS. Dit autrement, chaque circuit de pixel comprend un noeud connecté au rail VS et un noeud connecté au rail VCS.

La figure 2 illustre schématiquement un exemple du circuit de pixel PIX1 de la figure 1, les autres circuits de pixels PIX2 à PIXN de la figure 1 étant, de préférence, identiques ou similaires au circuit du pixel PIX1.

Le circuit de pixel PIX1 ou, plus simplement, le pixel PIX1, comprend une photodiode 102, par exemple une photodiode pincée. La photodiode 102 a une de ses électrodes, par exemple sa cathode, couplée à un noeud de détection SN du pixel. La photodiode 102 a, par exemple, l'autre de ses électrodes couplée à un rail d'un potentiel de polarisation Vpol.

En figure 2, la photodiode 102 est couplée au noeud SN par une porte de transfert, représentée par un commutateur 702. La porte de transfert 702 est disposée entre la photodiode 102 et le noeud de détection SN. La porte de transfert 702 est de préférence connecté au noeud SN. La porte de transfert 702 est contrôlée par un signal TG, par exemple fourni par un circuit de commande du capteur.

Le pixel PIX1 comprend un transistor MOS (de l'anglais "Metal Oxide Semiconductor" - métal oxyde semiconducteur) 204 ayant son noeud de commande (grille) connecté au noeud SN, et agencé pour fonctionner en suiveur de tension. Le transistor 204 a un de ses noeuds de conduction, par exemple son drain, couplé, de préférence connecté, au rail VCS, et l'autre de ses noeuds de conduction, par exemple sa source, couplé au rail VS.

Le transistor 204 est couplé au rail VS par un transistor MOS de lecture 504 contrôlé par un signal de lecture RD, par exemple fourni par un circuit de commande du capteur. Par exemple, le transistor 504 a un de ses noeuds de conduction, par exemple sa source, connecté au rail VS, et l'autre de ses noeuds de conduction, par exemple son drain, connecté au transistor 204, par exemple à la source du transistor 204.

Le pixel PIX1 comprend en outre un transistor MOS 502 de réinitialisation du noeud SN. Le transistor 502 est contrôlé par un signal RST, par exemple fourni par un circuit de commande du capteur. Le transistor 502 est couplé par ses noeuds de conduction entre le noeud SN et un rail de tension de réinitialisation VRST.

Dans l'exemple de la figure 2, les transistors 502, 204 et 504 sont à canal P (PMOS) . Ainsi, le potentiel VRST est un potentiel bas, par exemple un potentiel plus proche d'un potentiel d'alimentation bas que d'un potentiel d'alimentation haut de la colonne 400 (figure 1). Le transistor 502 a par exemple sa source couplée, de préférence connectée, au rail VRST, et son drain couplé, de préférence connecté, au noeud SN. Le potentiel Vpol est par exemple le potentiel de masse GND.

En se référant de nouveau à la figure 1, une source de courant 402 couple le rail VCS à un rail d'alimentation bas configuré pour recevoir le potentiel d'alimentation bas, par exemple le potentiel de masse GND. La source de courant 402 est configurée pour délivrer un courant I, de préférence constant. Par exemple, une borne de la source de courant 402 est connectée au rail VCS, l'autre borne de la source de courant 402 étant connectée au rail d'alimentation bas GND.

En outre, une impédance variable 404 couple le rail VS à un rail d'alimentation haut configuré pour recevoir le potentiel d'alimentation haut Vdd. L'impédance variable 404 est contrôlée par un amplificateur différentiel 406. L'impédance variable 404 est par exemple mise en oeuvre par un transistor PMOS dans l'exemple de la figure 1 où les pixels ont des transistors 204 à canal P. L'impédance variable 404 a par exemple une borne de conduction connectée au rail VS et une autre borne de conduction connectée au rail d'alimentation VDD. Par exemple, le potentiel d'alimentation VDD est haut par rapport au potentiel d'alimentation bas GND.

L'amplificateur différentiel 406 contrôle l'impédance variable 404 sur la base de la tension sur le rail de tension VCS. Dans l'exemple de la figure 1, l'amplificateur différentiel 406 a l'une de ses entrées, dans cet exemple son entrée positive, couplée au rail de tension VCS, et son autre entrée, dans cet exemple son entrée négative, couplée à un circuit 408 (bloc "CALIB. CIRCUIT" en figure 1), qui fournit une tension de référence VREF. Par exemple, la tension de référence VREF est une tension qui varie en fonction d'au moins la température afin d'assurer une compensation de température. Dans des variantes de réalisation, la tension de référence VREF pourrait être fixe, ou pourrait dépendre d'autres paramètres comme le procédé de fabrication, la tension d'alimentation ou la tension du rail de tension VS.

Lors d'une opération de lecture d'un pixel de la colonne 400, le transistor 504 du pixel (figure 2) est mis à l'état passant alors que les transistors 504 des autres pixels de la colonne 400 (figure 1) sont maintenus à l'état bloqué. Lorsque le transistor 504 du pixel est à l'état passant, une tension VSN du noeud SN du pixel détermine une tension sur le rail VS. Une lecture de la tension du noeud SN correspond alors à une mémorisation ou à un échantillonnage de la tension sur le rail VS, par exemple sur un condensateur d'échantillonnage (non illustré). Une borne du condensateur d'échantillonnage est par exemple couplée au rail VS, par exemple par un commutateur. Une autre borne du condensateur d'échantillonnage est, par exemple, couplée au rail d'alimentation GND.

Un double échantillonnage corrélé (CDS de l'anglais "Correlated Double Sampling") est mis en oeuvre lors de l'opération de lecture du pixel. Par exemple, une première tension du rail VS déterminée par un niveau de réinitialisation du noeud SN est mémorisée ou échantillonnée, par exemple sur un premier condensateur d'échantillonnage, lors d'une lecture du niveau de réinitialisation du noeud SN, et une deuxième tension du rail VS déterminée par un niveau de signal du noeud SN est mémorisée, par exemple sur un deuxième condensateur d'échantillonnage, lors d'une lecture du niveau de signal du noeud SN. Ainsi, l'opération de lecture d'un pixel en mettant en oeuvre un double échantillonnage corrélé comprend une lecture du niveau de réinitialisation du noeud SN, suivie d'une lecture du niveau de signal du noeud SN.

Le niveau de réinitialisation du noeud SN correspond par exemple à la tension VSN du noeud SN à la fin d'une phase de réinitialisation du noeud SN. Une phase de réinitialisation est par exemple mise en oeuvre en commutant le transistor 502 à l'état passant, et prend fin, par exemple, en commutant le transistor 502 à l'état bloqué.

Le niveau de signal du noeud SN correspond par exemple à la tension VSN du noeud SN lorsque celle-ci est déterminée par une quantité de lumière reçue par le pixel pendant une période d'intégration. Par exemple, le niveau de signal du noeud SN correspond à la tension VSN du noeud SN après que la porte de transfert 702 ait été commutée successivement à l'état passant puis à l'état bloqué alors que le transistor 502 est à l'état bloqué.

La figure 3 est un chronogramme illustrant un exemple des caractéristiques temporelles de signaux dans le circuit de pixel de la figure 2, et en particulier les caractéristiques temporelles des signaux RST, TG et RD. Dans l'exemple de la figure 3, les tensions VSN et VS ne sont pas illustrées.

Le signal RST est initialement à un état, par exemple à l'état bas dans cet exemple où le transistor 502 est à canal P, pour que le noeud de détection SN soit couplé à la tension VRST (transistor 502 passant). Cela correspond à une phase de réinitialisation du noeud SN, par exemple à un niveau bas. Pendant que le noeud SN est couplé à la tension VRST, une impulsion 802 du signal TG, par exemple à l'état bas dans cet exemple où les transistors du pixel sont à canal P, provoque la mise à l'état passant de la porte de transfert 702 et la réinitialisation d'une tension VSENSE aux bornes de la photodiode 102. La fin de l'impulsion 802 marque le début d'une période d'intégration T_INT.

Pour chaque opération de lecture du pixel, le signal de réinitialisation RST est amené à un état, par exemple l'état haut dans cet exemple où le transistor 502 est à canal P, pendant une période 804 pour isoler le noeud de détection SN du rail VRST (transistor 502 à l'état bloqué). Cela marque la fin de la phase de réinitialisation du noeud SN.

Pendant la période 804, le signal de lecture RD est amené à un état, par exemple l'état bas dans cet exemple où le transistor 504 est à canal P, pendant une période 806 pour que le transistor 504 soit passant et que la tension VS soit déterminée par la tension VSN du noeud SN.

Pendant la période 806, une impulsion 808 du signal TG, par exemple à l'état bas, provoque la mise à l'état passant de la porte de transfert 702 et le transfert de charges de la photodiode 102 vers le noeud SN, d'où il résulte que, dans cet exemple, la tension VSN du noeud SN augmente. La fin de l'impulsion 808 marque la fin de la période d'intégration T_INT.

Comme cela est représenté par des flèches 810 et 812, un double échantillonnage corrélé est mis en oeuvre pendant l'opération de lecture (période 806), en échantillonnant les tensions sur le rail VS, par exemple avec des condensateurs d'échantillonnage, avant et après l'impulsion 808 du signal TG. L'échantillonnage de la tension VS avant l'impulsion 808 permet de capturer le niveau de réinitialisation du noeud SN, et l'échantillonnage de la tension VS après l'impulsion 808 permet de capturer le niveau de signal du noeud SN. Le niveau de signal du noeud SN est déterminé par la valeur de la tension VSENSE à la fin de la période d'intégration T_INT, c'est-à-dire à la fin de l'impulsion 808, donc par la quantité de charges photogénérées dans le pixel pendant la période T_INT.

Dans l'exemple décrit en relation avec les figures 1, 2 et 3, le niveau de réinitialisation du noeud SN est un niveau bas et le niveau de signal du noeud SN est un niveau haut. A titre d'exemple, le niveau de signal est un niveau haut relativement au niveau bas de réinitialisation du noeud SN.

Les figures 1, 2 et 3 décrites précédemment concernent des exemples où le transistor suiveur de tension 204 des pixels est un transistor PMOS, et, où, plus généralement, les transistors du pixel sont à canal P. Toutefois, dans d'autres exemples ce transistor suiveur de tension est un transistor NMOS, et, plus généralement, les transistors du pixel sont à canal N comme cela va maintenant être illustré par les figures 4 et 5.

La figure 4 est une reproduction de la figure numérotée 9 des documents susmentionnés. Plus particulièrement, la figure 4 illustre schématiquement une colonne 900 d'une matrice de pixels d'un capteur d'image selon un autre exemple de réalisation. Bien que cela ne soit pas illustré en figure 4, la matrice de pixels peut comprendre une pluralité de colonnes 900. En outre, comme pour une colonne 400, la colonne 900 peut comprend un ou plusieurs pixels (bloc "PIXELS" en figure 4) chacun connecté entre le rail VCS et le rail VS, et étant, de préférence, identiques les uns aux autres.

L'exemple de la figure 4 est similaire à celui de la figure 1, excepté que le transistor suiveur de tension se trouvant dans chaque pixel (non illustré en figure 4) est mis en oeuvre par un transistor NMOS plutôt que par un transistor PMOS.

Ainsi, la source de courant 402 de la figure 1 est remplacée par une source de courant 902 disposée entre le rail de tension VCS et le rail d'alimentation haut VDD. La source de courant 902 est configurée pour délivrer un courant I, de préférence constant. Par exemple, une borne de la source de courant 902 est connectée au rail VCS, l'autre borne de la source de courant 902 étant connectée au rail d'alimentation haut VDD.

En outre, à la place de l'impédance variable 404 de la figure 1, une impédance variable 904 est disposée entre le rail de sortie de tension VS et le rail d'alimentation bas GND, et est contrôlée par l'amplificateur différentiel 406. L'impédance variable 904 est par exemple mise en oeuvre par un transistor NMOS. L'impédance variable 904 a par exemple une borne de conduction connectée au rail VS et une autre borne de conduction connectée au rail d'alimentation bas GND.

La figure 5 illustre schématiquement un exemple de pixel de la matrice de pixels de la figure 4, ce pixel étant référencé PIX1 en figure 5. Les autres pixels de la figure 4 sont, de préférence, mis en oeuvre de manière identique ou similaire à ce pixel PIX1.

Le pixel PIX1 de la figure 5 diffère du pixel PIX1 décrit précédemment en relation avec la figure 2 ce que :
- le transistor PMOS 204 est remplacé par un transistor NMOS 104,
- le transistor PMOS 502 est remplacé par un transistor NMOS 1002, et
- le transistor PMOS 504 est remplacé par un transistor NMOS 1004.

Plus particulièrement, le transistor 104 est agencé pour fonctionner en suiveur de tension. Un noeud de conduction principal du transistor 104, par exemple sa source, est couplé au rail VS par le transistor 1004 et l'autre noeud de conduction principal du transistor 104, par exemple son drain, est couplé, de préférence connecté, au rail VCS. Le transistor 1004 a un de ses noeuds de conduction, par exemple sa source, connecté au rail VS, et l'autre de ses noeuds de conduction, par exemple son drain, connecté au transistor 104, par exemple à la source du transistor 104.

Dans l'exemple de la figure 5, les transistors 104, 1002 et 1004 sont à canal N (NMOS). Ainsi, le potentiel VRST est un potentiel haut, par exemple un potentiel plus proche du potentiel d'alimentation haut VDD que du potentiel d'alimentation bas GND. Le transistor 1002 a par exemple sa source couplée, de préférence connectée, au noeud SN, et son drain couplé, de préférence connecté, au rail VRST. A titre d'exemple, le potentiel Vpol est égal ou sensiblement égal au potentiel de masse GND.

Le fonctionnement du pixel de la figure 5 est par exemple similaire à celui du pixel de la figure 2, excepté que les signaux de commande RD et RST sont adaptés pour tenir compte de l'utilisation de transistors NMOS à la place de transistors PMOS, par exemple en inversant les niveaux haut et bas de ces signaux.

Ainsi, dans l'exemple décrit en relation avec les figures 4 et 5, le niveau de réinitialisation du noeud SN est un niveau haut et le niveau de signal du noeud SN est un niveau bas. A titre d'exemple, le niveau de signal est un niveau bas relativement au niveau haut de réinitialisation du noeud SN.

Dans les exemples précédents où le transistor suiveur de tension 204 est un transistor PMOS, l'impédance 404 et sa boucle de commande permettent d'accélérer la charge du rail VS entre le début de l'impulsion 808 et l'instant 812 de mémorisation de la tension VS correspondant au niveau de signal du noeud SN. Dit autrement, l'impédance 404 et sa boucle de commande permettent de réduire le temps d'établissement d'un signal montant sur le rail VS provoqué par l'impulsion 808, avant la lecture du niveau de signal du noeud SN. En revanche, la vitesse de décharge du rail VS entre le début de la période 806 et l'instant 810 de mémorisation de la tension VS correspondant au niveau de réinitialisation du noeud SN reste limitée par la valeur du courant I et la valeur de capacité du rail VS. Dit autrement, le temps d'établissement d'un signal descendant sur le rail VS provoqué par la mise à l'état passant du transistor de lecture 504 (figure 2) reste limité par la valeur du courant I et la valeur de capacité du rail VS. Par exemple, suite à la mise à l'état passant du transistor de lecture 504 alors que le noeud SN est à son niveau de réinitialisation qui est un niveau bas, le temps nécessaire pour que la tension du rail VS diminue jusqu'à une valeur stable déterminée par le niveau de réinitialisation du noeud SN, augmente avec la valeur de capacité du rail VS et avec l'amplitude de la différence entre la valeur de la tension VS au début de la période 806 et la valeur stable déterminée par le niveau de réinitialisation, ce qui augmente la durée nécessaire à la lecture du niveau de réinitialisation du noeud SN.

Il serait souhaitable de réduire la durée nécessaire à la lecture d'un niveau de réinitialisation du noeud SN d'un pixel ayant un transistor suiveur de tension 204 de type PMOS.

De manière similaire, dans les exemples précédents où le transistor suiveur de tension est un transistor NMOS, l'impédance 904 et sa boucle de commande permettent d'accélérer la décharge du rail VS entre le début de l'impulsion 808 et l'instant 812 de mémorisation de la tension VS correspondant au niveau de signal du noeud SN. Dit autrement, l'impédance 904 et sa boucle de commande permettent de réduire le temps d'établissement d'un signal descendant sur le rail VS provoqué par l'impulsion 808, avant la lecture du niveau de signal du noeud SN. En revanche, la vitesse de charge du rail VS entre le début de la période 806 et l'instant 810 de mémorisation de la tension VS correspondant au niveau de réinitialisation du noeud SN reste limitée par la valeur du courant I et la valeur de capacité du rail VS. Dit autrement, le temps d'établissement d'un signal montant sur le rail VS provoqué par la mise à l'état passant du transistor de lecture 1004 (figure 5) reste limité par la valeur du courant I et la valeur de capacité du rail VS. Par exemple, suite à la mise à l'état passant du transistor de lecture 1004 alors que le noeud SN est à son niveau de réinitialisation qui est un niveau haut, le temps nécessaire pour que la tension du rail VS augmente jusqu'à une valeur stable déterminée par le niveau de réinitialisation du noeud SN, augmente avec la valeur de capacité du rail VS et avec l'amplitude de la différence entre la valeur de la tension VS au début de la période 806 et la valeur stable déterminée par le niveau de réinitialisation, ce qui augmente la durée nécessaire à la lecture du niveau de réinitialisation du noeud SN.

Il serait souhaitable de réduire la durée nécessaire à la lecture d'un niveau de réinitialisation du noeud SN d'un pixel ayant un transistor suiveur de tension 104 de type NMOS.

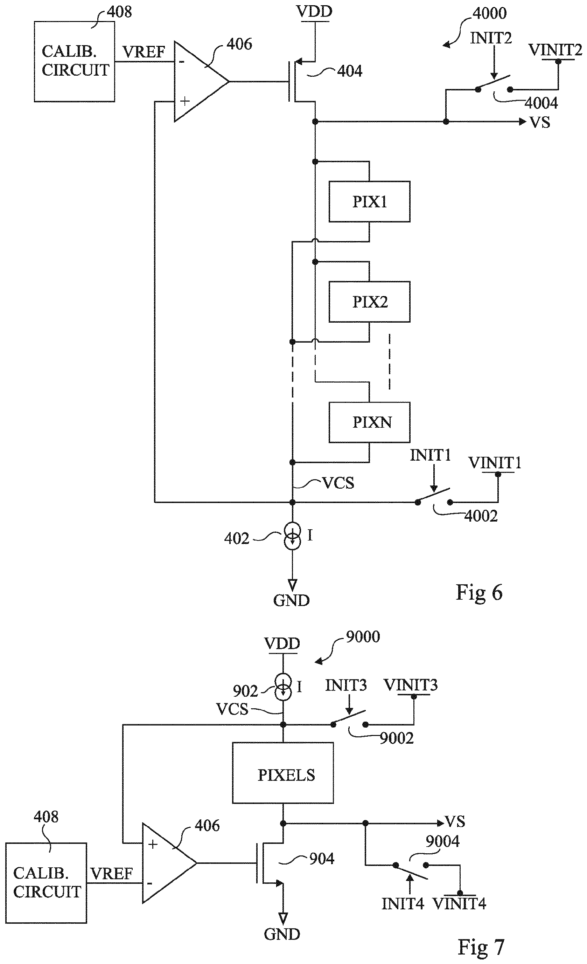

La figure 6 illustre schématiquement un mode de réalisation d'une colonne 4000 d'une matrice de pixels d'un capteur d'image ou de lumière, la matrice pouvant comprendre une pluralité de colonnes 4000.

La colonne 4000 de pixels comprend de nombreux éléments en commun avec la colonne 400 décrite en relation avec la figure 1. Ainsi, sauf indication contraire, ce qui a été décrit pour la colonne 400 s'applique à la colonne 4000, et seules les différences entre la colonne 400 et la colonne 4000 sont mises en exergue. En particulier, dans la colonne 4000, les pixels ont des transistors 204 de type PMOS. Par exemple, tous les pixels de la colonne 4000 sont tels que décrits en relation avec la figure 2.

La colonne 4000 diffère de la colonne 400 en ce qu'elle comprend un commutateur 4002 couplant le rail de tension VCS à un rail de tension VINIT1.

Le commutateur 4002 a une borne de conduction couplée, de préférence connectée, au rail VCS, et une autre borne de conduction couplée, de préférence connectée, au rail VINIT1. Le commutateur 4002 est contrôlé par un signal INIT1, par exemple fourni par un circuit de commande du capteur. A titre d'exemple, le commutateur 4002 est mis en oeuvre par un transistor MOS.

La tension VINIT1 est configuré pour que, lorsque le rail VCS est forcé à la tension VINIT1 par une fermeture du commutateur 4002, l'impédance 404 soit équivalente à un circuit ouvert. Cela permet d'isoler le rail VS du rail d'alimentation VDD. La tension VINIT1 est donc ici supérieure à la tension VREF.

Selon un mode de réalisation, pour chaque opération de lecture d'un pixel, le commutateur 4002 est commuté à l'état passant avant le début de la période 806 pendant laquelle le transistor 504 (figure 2) est passant.

La colonne 4000 comprend en outre un commutateur 4004 couplant le rail de tension VS à un rail de tension VINIT2. Le commutateur 4004 a une borne de conduction couplée, de préférence connectée, au rail VS, et une autre borne de conduction couplée, de préférence connectée, au rail VINIT2. Le commutateur 4004 est contrôlé par un signal INIT2, par exemple fourni par un circuit de commande du capteur. A titre d'exemple, le commutateur 4004 est mis en oeuvre par un transistor MOS.

Pour chaque opération de lecture d'un pixel, alors que le rail VCS est forcé à la tension VINIT1 (commutateur 4002 fermé et impédance 404 équivalente à un circuit ouvert), le rail VS est forcé à la tension VINIT2 par une fermeture du commutateur 4004 avant le début de la période 806 pendant laquelle le transistor 504 (figure 2) est passant. La valeur de la tension VINIT2 est basse, c'est-à-dire plus proche de la tension sur le rail d'alimentation bas GND que de la tension sur le rail d'alimentation haut VDD. Par exemple, la tension VINIT2 a une valeur sensiblement égale et par exemple inférieure à une valeur stable de la tension VS déterminée par le niveau de réinitialisation du noeud SN. Dit autrement, la tension VINIT2 est par exemple déterminée par la tension VRST.

Une fois que le rail VS a été forcé à la tension VINIT2, les deux commutateurs 4002 et 4004 sont commutés à l'état bloqué. Plus particulièrement, au moins le commutateur 4004 est commuté à l'état bloqué avant le début de la période 806, par exemple entre le début de la période 804 et le début de la période 806, le commutateur 4002 pouvant être commuté à l'état bloqué plus tard, par exemple pendant la période 806 et avant l'instant 810.

Forcer la tension VINIT2 sur le rail VS avant le début de la période 806 permet de décharger au moins en partie le rail VS. Cela permet de réduire le temps d'établissement de la tension VS lors de la lecture du niveau de réinitialisation du noeud SN.

La figure 7 illustre schématiquement un autre mode de réalisation d'une colonne 9000 d'une matrice de pixels d'un capteur d'image ou de lumière, la matrice pouvant comprendre une pluralité de colonnes 9000.

La colonne 9000 de pixels comprend de nombreux éléments en commun avec la colonne 900 décrite en relation avec la figure 4. Ainsi, sauf indication contraire, ce qui a été décrit pour la colonne 900 s'applique à la colonne 9000, et seules les différences entre la colonne 900 et la colonne 9000 sont mises en exergue. En particulier, dans la colonne 9000, les pixels ont des transistors 104 de type NMOS. Par exemple, tous les pixels de la colonne 9000 sont tels que décrits en relation avec la figure 5.

La colonne 9000 diffère de la colonne 900 en ce qu'elle comprend un commutateur 9002 couplant le rail de tension VCS à un rail de tension VINIT3.

Le commutateur 9002 a une borne de conduction couplée, de préférence connectée, au rail VCS, et une autre borne de conduction couplée, de préférence connectée, au rail VINIT3. Le commutateur 9002 est contrôlé par un signal INIT3, par exemple fourni par un circuit de commande du capteur. A titre d'exemple, le commutateur 9002 est mis en oeuvre par un transistor MOS.

La tension VINIT3 est configuré pour que, lorsque le rail VCS est forcé à la tension VINIT3 par une fermeture du commutateur 9002, l'impédance 904 soit équivalente à un circuit ouvert. Cela permet d'isoler le rail VS du rail d'alimentation GND. La tension VINIT3 est donc ici inférieure à la tension VREF.

Selon un mode de réalisation, pour chaque opération de lecture d'un pixel, le commutateur 9002 est commuté à l'état passant avant le début de la période 806 où le transistor 104 (figure 5) du pixel est passant.

La colonne 9000 comprend en outre un commutateur 9004 couplant le rail de tension VS à un rail de tension VINIT4. Le commutateur 9004 a une borne de conduction couplée, de préférence connectée, au rail VS, et une autre borne de conduction couplée, de préférence connectée, au rail VINIT4. Le commutateur 9004 est contrôlé par un signal INIT4, par exemple fourni par un circuit de commande du capteur. A titre d'exemple, le commutateur 9004 est mis en oeuvre par un transistor MOS.

Pour chaque opération de lecture d'un pixel, alors que le rail VCS est forcé à la tension VINIT3 (commutateur 9002 passant et impédance 904 équivalente à un circuit ouvert), le rail VS est forcé à la tension VINIT4 par une fermeture du commutateur 9004 avant le début de la période 806 où le transistor 104 (figure 5) du pixel est passant. La valeur de la tension VINIT4 est haute, c'est-à-dire qu'elle est plus proche de la tension du rail d'alimentation haut VDD que de la tension du rail d'alimentation bas GND. Par exemple, la tension VINIT4 a une valeur sensiblement égale et par exemple inférieure à une valeur stable de la tension VS déterminée par le niveau de réinitialisation du noeud SN. Dit autrement, la tension VINIT4 est par exemple déterminée par la tension VRST.

Une fois que le rail VS a été forcé à la tension VINIT4, les deux commutateurs 9002 et 9004 sont commutés à l'état bloqué. Plus particulièrement, au moins le commutateur 9004 est commuté à l'état bloqué avant le début de la période 806, par exemple entre le début de la période 804 et le début de la période 806, le commutateur 9002 pouvant être commuté à l'état bloqué plus tard, par exemple pendant la période 806 et avant l'instant 810.

Forcer la tension VINIT4 sur le rail VS avant le début de la période 806 permet de charger au moins en partie le rail VS. Cela permet de réduire le temps d'établissement de la tension VS lors de la lecture du niveau de réinitialisation du noeud SN.

Divers modes de réalisation et diverses variantes ont été décrits. La personne du métier comprendra que certains éléments de ces modes de réalisation peuvent être combinés et d'autres variantes apparaîtront facilement à la personne du métier.

Par exemple, bien qu'on ait décrit deux exemples particuliers de pixels, il apparaîtra clairement à la personne de l'art que les principes décrits ici pourraient s'appliquer à tout circuit de pixel permettant la mise en oeuvre d'un double échantillonnage corrélé, par exemple des pixels comprenant chacun un transistor suiveur ayant sa grille connectée à un noeud de détection du pixel, le noeud de détection étant connecté à une porte de transfert couplant le noeud de détection à une photodiode.

En outre, bien que dans les exemples décrits ici les impédances variables 404, 904 soit mises en oeuvre par des transistors, dans des variantes de réalisation elles pourraient être mises en oeuvre par d'autres dispositifs, comme des résistances variables.

Bien que l'on ait décrit des circuits comprenant un rail d'alimentation bas au potentiel de masse GND, il apparaîtra à la personne du métier que le potentiel du rail d'alimentation bas peut être différent du potentiel de masse GND, par exemple être à un potentiel négatif par rapport à la masse GND.

En outre, la personne du métier est en mesure de choisir un potentiel Vpol différent de la masse GND, et plus généralement d'adapter le sens de connexion de la photodiode PD, par exemple pour assurer que la photodiode PD soit pincée.

Bien que l'on ait décrit en relation avec la figure 3 un exemple de commande d'un pixel dans lequel le transistor 502 ou 1002 de réinitialisation du noeud SN est commuté à l'état bloqué avant la mise à l'état passant du transistor de lecture 504 ou 1004, la personne du métier est en mesure d'adapter la description faite ci-dessus de mode de réalisation au cas où le transistor 502 ou 1002 de réinitialisation du noeud SN est commuté à l'état bloqué après la mise à l'état passant du transistor de lecture 504 ou 1004, mais avant l'instant 810 de mémorisation du niveau de signal du noeud SN.

Enfin, la mise en oeuvre pratique des modes de réalisation et variantes décrits est à la portée de la personne du métier à partir des indications fonctionnelles données ci-dessus. En particulier, le choix des tensions Vpol, VREF, VINIT1, VINIT2, VINIT3 et VINIT4 est à la portée de la personne du métier.

## Revendications

1. Matrice de pixels, comprenant :
- un ou plusieurs pixels (PIX1) comprenant chacun un premier transistor (204, 104) ayant : son noeud de commande (SN) couplé à une photodiode (102) ; un premier de ses noeuds de conduction principaux couplé à un premier rail de tension de sortie (VS) ; et un deuxième de ses noeuds de conduction principaux couplé à un deuxième rail de tension (VCS) ;
- une impédance variable (404, 904) couplant le premier rail de tension (VS) à un premier rail d'alimentation (VDD, GND) de la matrice de pixels ;
- une source de courant (402, 902) couplant le deuxième rail de tension (VCS) à un deuxième rail d'alimentation (GND, VDD) de la matrice de pixels, l'impédance variable (404, 904) étant contrôlée sur la base d'une tension sur le deuxième rail de tension (VCS) ;
**caractérisée par** :
- un premier commutateur (4002, 9002) couplant le deuxième rail de tension (VCS) à un troisième rail de tension (VINIT1, VINIT3) .

2. Matrice de pixels selon la revendication 1, comprenant en outre un amplificateur différentiel (406) ayant une première entrée couplée au deuxième rail de tension (VCS), une deuxième entrée couplée à une tension de référence (VREF), et une sortie couplée à une entrée de commande de l'impédance variable (404, 904).

3. Matrice de pixels selon la revendication 2, comprenant un circuit (408) configuré pour fournir la tension de référence (VREF) et pour modifier la tension de référence (VREF) au moins en fonction de la température.

4. Matrice de pixels selon l'une quelconque des revendications 1 à 3, dans lequel une tension (VINIT1, VINIT3) du troisième rail de tension est configurée pour qu'une fermeture du premier commutateur (4002, 9002) rende l'impédance variable (404, 904) équivalente à un circuit ouvert.

5. Matrice de pixels selon l'une quelconque des revendications 1 à 4, comprenant en outre un deuxième commutateur (4004, 9004) couplant le premier rail de tension (VS) à un quatrième rail de tension (VINIT2, VINIT4).

6. Matrice de pixels selon la revendication 5, dans laquelle la tension (VINIT2, VINIT4) du quatrième rail de tension est plus proche d'une tension sur le deuxième rail d'alimentation (GND, VDD) que d'une tension sur le premier rail d'alimentation (VDD, GND).

7. Matrice de pixels selon l'une quelconque des revendications 1 à 6, dans laquelle chaque pixel (PIX1) comprend en outre un deuxième transistor (502, 1002) couplant le noeud de commande (SN) du premier transistor (204, 104) à un rail de tension de réinitialisation (VRST), et un troisième transistor (504, 1004) couplant le premier noeud de conduction du premier transistor (204, 104) au premier rail de tension (VS).

8. Matrice de pixels selon la revendication 7, dans laquelle une tension du rail de tension de réinitialisation détermine une valeur de la tension (VINIT2, VINIT4) du quatrième rail de tension.

9. Matrice de pixels selon l'une quelconque des revendications 1 à 8, dans laquelle chaque pixel (PIX1) comprend en outre une porte de transfert (702) couplant le noeud de commande (SN) du premier transistor (204, 104) à la photodiode (102).

10. Procédé de commande d'un pixel (PIX1) d'une matrice de pixels, le procédé comprenant, pour chaque opération de lecture du pixel (PIX1), une fermeture d'un premier commutateur (4002, 9002) couplant un deuxième rail de tension (VCS) à un troisième rail de tension (VINIT1, VINIT3), le deuxième rail de tension (VS) étant couplé à un deuxième noeud de conduction d'un premier transistor (204, 104) du pixel ayant un premier noeud de conduction couplé à un premier rail de tension de sortie (VS) et un noeud de commande (SN) couplé à une photodiode (102) du pixel, le premier rail de tension (VS) étant couplé à un premier rail d'alimentation (VDD, GND) par une impédance variable (404, 904) et le deuxième rail de tension (VCS) étant couplé à un deuxième rail d'alimentation (GND, VDD) par une source de courant (402, 902), l'impédance variable (404, 904) étant commandée sur la base d'une tension sur le deuxième rail de tension (VCS).

11. Procédé selon la revendication 10, dans lequel une tension du troisième rail de tension (VINIT1, VINIT3) est configurée pour qu'une fermeture du premier commutateur (4002, 9002) rende l'impédance variable (404, 904) équivalente à un circuit ouvert.

12. Procédé selon la revendication 10 ou 11, dans lequel :
- chaque pixel (PIX1) comprend en outre un deuxième transistor (502, 1002) couplant le noeud de commande (SN) du premier transistor (204, 104) à un rail de tension de réinitialisation (VRST), et un troisième transistor (504, 1004) couplant le premier noeud de conduction du premier transistor (204, 104) au premier rail de tension (VS) ; et
- la fermeture du premier commutateur (4002) est mise en oeuvre avant une période (806) où le troisième transistor (504, 1004) est maintenu passant.

13. Procédé selon la revendication 12, dans lequel un deuxième commutateur (4004) couple un quatrième rail de tension (VINIT2) au premier rail de tension (VS) et est commuté à l'état passant pendant que le premier commutateur (4002) est fermé.

14. Procédé selon la revendication 13, dans lequel une tension (VRST) du rail de tension de réinitialisation détermine une valeur de la tension (VINIT2, VINIT4) du quatrième rail de tension.

15. Procédé selon la revendication 13, dans lequel une tension (VINIT2, VINIT4) du quatrième rail de tension est plus proche d'une tension sur le deuxième rail d'alimentation (GND, VDD) que d'une tension sur le premier rail d'alimentation (VDD, GND).

## Patentansprüche

1. Pixelanordnung, die Folgendes aufweist:
- ein oder eine Vielzahl von Pixeln (PIX1), die jeweils einen ersten Transistor (204, 104) aufweisen, dessen erster Steuerknoten (SN) mit einer Fotodiode (102) gekoppelt ist, wobei ein erster seiner Hauptleitungsknoten mit einer ersten Ausgangsspannungsschiene (VS) gekoppelt ist; und wobei ein zweiter seiner Hauptleitungsknoten mit einer zweiten Spannungsschiene (VCS) gekoppelt ist;
- eine variable Impedanz (404, 904), welche die erste Spannungsschiene (VS) mit einer ersten Leistungslieferschiene (VDD, GND) der Pixelanordnung koppelt;
- eine Stromquelle (402, 902), welche die zweite Spannungsschiene (VCS) mit einer zweiten Leistungslieferschiene (GND, VDD) der Pixelanordnung koppelt, wobei die variable Impedanz (404, 904) basierend auf einer Spannung auf der zweiten Spannungsschiene (VCS) gesteuert wird; **gekennzeichnet durch**:
- einen ersten Schalter (4002, 9002), der die zweite Spannungsschiene (VCS) mit einer dritten Spannungsschiene (VINIT1, VINIT3) koppelt.

2. Pixelanordnung nach Anspruch 1, die weiter einen Differentialverstärker (406) mit einem ersten Eingang aufweist, der mit der zweiten Spannungsschiene (VCS) gekoppelt ist, mit einem zweiten Eingang, der mit einer Referenzspannung (VREF) gekoppelt ist, und mit einem Ausgang, der mit einem Steuereingang der variablen Impedanz (404, 904) gekoppelt ist.

3. Pixelanordnung nach Anspruch 2, die eine Schaltung (408) aufweist, welche konfiguriert ist, um die Referenzspannung (VREF) zu liefern und die Referenzspannung (VREF) zumindest gemäß der Temperatur zu modifizieren.

4. Pixelanordnung nach einem der Ansprüche 1 bis 3, wobei eine Spannung (VINIT1, VINIT3) der dritten Spannungsschiene so konfiguriert ist, dass ein Schließen des ersten Schalters (4002; 9002) die variable Impedanz (404, 904) äquivalent zu einem offenen Schaltkreis macht.

5. Pixelanordnung nach einem der Ansprüche 1 bis 4, die weiter einen zweiten Schalter (4004, 9004) aufweist, der die erste Spannungsschiene (VS) mit einer vierten Spannungsschiene (VINIT2, VINIT4) koppelt.

6. Pixelanordnung nach Anspruch 5, wobei die Spannung (VINIT2, VINIT4) der vierten Spannungsschiene näher an einer Spannung auf der zweiten Leistungslieferschiene (GND, VDD) ist als an einer Spannung auf der ersten Leistungslieferschiene (VDD, GND).

7. Pixelanordnung nach einem der Ansprüche 1 bis 6, wobei jedes Pixel (PIX1) weiter einen zweiten Transistor (502, 1002) aufweist, der den Steuerknoten (SN) des ersten Transistors (204, 104) mit einer Rücksetz- bzw. Reset-Spannungsschiene (VRST) koppelt, und einen dritten Transistor (504, 1004), der dem ersten Leitungsknoten des ersten Transistors (204, 104) mit der ersten Spannungsschiene (VS) koppelt.

8. Pixelanordnung nach Anspruch 7, wobei eine Spannung der Reset-Spannungsschiene einen Wert der Spannung (VINIT2, VINIT4) der vierten Spannungsschiene bestimmt.

9. Pixelanordnung nach einem der Ansprüche 1 bis 8, wobei jedes Pixel (PIX1) weiter ein Transfergatter bzw. Transfer-Gate (702) aufweist, welches den Steuerknoten (SN) des ersten Transistors (204, 104) mit der Fotodiode (102) koppelt.

10. Verfahren zum Steuern eines Pixels (PIX1) einer Pixelanordnung, wobei das Verfahren für jede Leseoperation des Pixels (PIX1) Folgendes aufweist: Schließen eines ersten Schalters (4002, 9002), der eine zweite Spannungsschiene (VCS) mit einer dritten Spannungsschiene (VINIT1, VINIT3) koppelt, wobei die zweite Spannungsschiene (VS) mit einem zweiten Leitungsknoten eines ersten Transistors (204, 104) des Pixels koppelt, bei dem ein erster Leitungsknoten mit einer ersten Ausgangsspannungsschiene (VS) gekoppelt ist, und wobei ein Steuerknoten (SN) mit einer Fotodiode (102) des Pixels gekoppelt ist, wobei die erste Spannungsschiene (VS) mit einer ersten Leistungslieferschiene (VDD, GND) durch eine variable Impedanz (404, 904) gekoppelt ist, und wobei die zweite Spannungsschiene (VCS) mit einer zweiten Leistungslieferschiene (GND, VDD) durch eine Stromquelle (402, 902) gekoppelt ist, wobei die variable Impedanz (404, 904) basierend auf einer Spannung der zweiten Spannungsschiene (VCS) gesteuert wird.

11. Verfahren nach Anspruch 10, wobei eine Spannung der dritten Spannungsschiene (VINIT1, VINIT3) so konfiguriert ist, dass ein Schließen des ersten Schalters (4002, 9002) die variable Impedanz (404, 904) äquivalent zu einem offenen Schaltkreis macht.

12. Verfahren nach Anspruch 10 oder 11, wobei:
- jedes Pixel (PIX1) einen zweiten Transistor (502, 1002) aufweist, welcher den Steuerknoten (SN) des ersten Transistors (204, 104) mit einer Rücksetz- bzw- Reset-Spannungsschiene (VRST) koppelt, und einen dritten Transistor (504, 1004), der den ersten Leitungsknoten des ersten Transistors (204, 104) mit der ersten Spannungsschiene (VS) koppelt; und
- das Schließen des ersten Schalters (4002) vor einer Periode (806) implementiert bzw. ausgeführt wird, während welcher der dritte Transistor (504, 1004) durchlassend gehalten wird.

13. Verfahren nach Anspruch 12, wobei ein zweiter Schalter (4004) eine vierte Spannungsschiene (VINIT2) mit der ersten Spannungsschiene (VS) koppelt und in den Durchlasszustand geschaltet ist, während der erste Schalter (4002) geschlossen ist.

14. Verfahren nach Anspruch 13, wobei eine Spannung (VRST) der Reset-Spannungsschiene einen Wert der Spannung (VINIT2, VINIT4) der vierten Spannungsschiene bestimmt.

15. Verfahren nach Anspruch 13, wobei eine Spannung (VINIT2, VINIT4) der vierten Spannungsschiene näher an einer Spannung der zweiten Leistungslieferschiene (GND, VDD) ist als an einer Spannung der ersten Leistungslieferschiene (VDD, GND).

## Claims

1. Pixel array, comprising:
- one or a plurality of pixels (PIX1), each comprising a first transistor (204, 104) having: its control node (SN) coupled to a photodiode (102); a first one of its main conduction nodes coupled to a first output voltage rail (VS); and a second one of its main conduction nodes coupled to a second voltage rail (VCS);
- a variable impedance (404, 904) coupling the first voltage rail (VS) to a first power supply rail (VDD, GND) of the pixel array;
- a current source (402, 902) coupling the second voltage rail (VCS) to a second power supply rail (GND, VDD) of the pixel array, the variable impedance (404, 904) being controlled based on a voltage on the second voltage rail (VCS); **characterized by**:
- a first switch (4002, 9002) coupling the second voltage rail (VCS) to a third voltage rail (VINIT1, VINIT3).

2. Pixel array according to claim 1, further comprising a differential amplifier (406) having a first input coupled to the second voltage rail (VCS), a second input coupled to a reference voltage (VREF), and an output coupled to a control input of the variable impedance (404, 904) .

3. Pixel array according to claim 2, comprising a circuit (408) configured to deliver the reference voltage (VREF) and to modify the reference voltage (VREF) at least according to temperature.

4. Pixel array according to any of claims 1 to 3, wherein a voltage (VINIT1, VINIT3) of the third voltage rail is configured so that a turning on of the first switch (4002, 9002) makes the variable impedance (404, 904) equivalent to an open circuit.

5. Pixel array according to any of claims 1 to 4, further comprising a second switch (4004, 9004) coupling the first voltage rail (VS) to a fourth voltage rail (VINIT2, VINIT4) .

6. Pixel array according to claim 5, wherein the voltage (VINIT2, VINIT4) of the fourth voltage rail is closer to a voltage on the second power supply rail (GND, VDD) than to a voltage on the first power supply rail (VDD, GND) .

7. Pixel array according to any of claims 1 to 6, wherein each pixel (PIX1) further comprises a second transistor (502, 1002) coupling the control node (SN) of the first transistor (204, 104) to a reset voltage rail (VRST), and a third transistor (504, 1004) coupling the first conduction node of the first transistor (204, 104) to the first voltage rail (VS).

8. Pixel array according to claim 7, wherein a voltage of the reset voltage rail determines a value of the voltage (VINIT2, VINIT4) of the fourth voltage rail.

9. Pixel array according to any of claims 1 to 8, wherein each pixel (PIX1) further comprises a transfer gate (702) coupling the control node (SN) of the first transistor (204, 104) to the photodiode (102).

10. Method of controlling a pixel (PIX1) of a pixel array, the method comprising, for each operation of reading of the pixel (PIX1), a turning on of a first switch (4002, 9002) coupling a second voltage rail (VCS) to a third voltage rail (VINIT1, VINIT3), the second voltage rail (VS) being coupled to a second conduction node of a first transistor (204, 104) of the pixel having a first conduction node coupled to a first output voltage rail (VS) and a control node (SN) coupled to a photodiode (102) of the pixel, the first voltage rail (VS) being coupled to a first power supply rail (VDD, GND) by a variable impedance (404, 904) and the second voltage rail (VCS) being coupled to a second power supply rail (GND, VDD) by a current source (402, 902), the variable impedance (404, 904) being controlled based on a voltage on the second voltage rail (VCS).

11. Method according to claim 10, wherein a voltage of the third voltage rail (VINIT1, VINIT3) is configured so that a turning on of the first switch (4002, 9002) makes the variable impedance (404, 904) equivalent to an open circuit.

12. Method according to claim 10 or 11, wherein:
- each pixel (PIX1) further comprises a second transistor (502, 1002) coupling the control node (SN) of the first transistor (204, 104) to a reset voltage rail (VRST), and a third transistor (504, 1004) coupling the first conduction node of the first transistor (204, 104) to the first voltage rail (VS); and
- the turning on of the first switch (4002) is implemented before a period (806) during which the third transistor (504, 1004) is held on.

13. Method according to claim 12, wherein a second switch (4004) couples a fourth voltage rail (VINIT2) to the first voltage rail (VS) and is switched to the on state while the first switch (4002) is on.

14. Method according to claim 13, wherein a voltage (VRST) of the reset voltage rail determines a value of the voltage (VINIT2, VINIT4) of the fourth voltage rail.

15. Method according to claim 13, wherein a voltage (VINIT2, VINIT4) of the fourth voltage rail is closer to a voltage on the second power supply rail (GND, VDD) than to a voltage on the first power supply rail (VDD, GND) .
